# EUROPEAN PATENT SPECIFICATION

(11) **EP 3 427 555 B1**
(45) Date of publication and mention of the grant of the patent: **09.02.2022**
(21) Application number: 17710052.6
(22) Date of filing: 09.02.2017
(51) Int. Cl.: H05K 1/02, H05K 1/18, F21S 4/22

(54) **A LIGHTING DEVICE AND CORRESPONDING METHOD**
BELEUCHTUNGSVORRICHTUNG UND ZUGEHÖRIGES VERFAHREN
DISPOSITIF D'ÉCLAIRAGE ET PROCÉDÉ CORRESPONDANT

(30) Priority: 07.03.2016 IT UA20161402
(43) Date of publication of application: 16.01.2019
(73) Proprietor: OSRAM GmbH, 80807 München (DE); OSRAM S.P.A. - SOCIETA' RIUNITE OSRAM EDISON CLERICI, 20126 Milano (IT)
(72) Inventor: GRIFFONI, Alessio, 30030 Fossò (Venezia) (IT); DIDONE', Roberto, 36027 Rosà (Vicenza) (IT); BALDO, Lorenzo, 31040 Giavera del Montello (Treviso) (IT); VOLPATO, Luca, 31022 Preganziol (Treviso) (IT)
(74) Representative: Bosotti, Luciano
(86) International application number: PCT/IB2017/050711
(87) International publication number: WO 2017/153856

(56) References cited:
- WO-A1-2015/159126
- JP-A- 2004 119 871
- US-A- 5 434 362
- US-A1- 2012 051 005
- US-A1- 2014 042 406
- US-A1- 2014 190 729
- US-A1- 2015 373 830

## Description

### Technical Field

The description relates to lighting devices.

One or more embodiments may refer to lighting devices employing electrically-powered light radiation sources, e.g. solid-state sources such as LED sources.

### Technological Background

Various applications in lighting technology, e.g. backlighting, signage lighting, ambient lighting or architectural lighting, may employ lighting device comprising linear modules, e.g. LED linear modules, adapted to bend or flex.

It is desirable for the module to be adapted to bend not only in the direction normal to the installation or lying plane of the module, but also in such plane.

Moreover, it is desirable that such modules may have a certain length together with low ohmic resistance of the electrical lines comprised therein - e.g. supply (e.g. 24 V) and ground - so as to exhibit a uniform current and luminous flux distribution along the length of the module.

Various solutions have been proposed to meet such needs.

For example, lamp-type LEDs may be soldered directly on electrical wires. This solution, however, has drawbacks as regards heat dissipation and the possible achievable length.

Another solution may envisage the connection (e.g. in parallel) of LED modules having the light source(s) (and optionally the associated driving circuitry) mounted on rigid boards, the interconnection among the boards being implemented via electrical wires. However, this solution cannot provide for small bending radiuses, especially in the installation or lying plane.

Another option involves mounting the sources onto double-sided Flexible Printed Circuit (FPC) boards, which may be produced with a meander-like pattern between two consecutive LEDs, e.g. with a so-called sheet-to-sheet (S2S) process. In such an arrangement, the meanders may comprise a single base film (e.g. polyimide - PI) with one conducting line or track (e.g. copper) for each signal (supply, VDD; ground, GND; and LED bias signal, I_{F}). Each meander, moreover, may have an opposite orientation with respect to the adjoining meander.

Although this solution may offer better performances than the previous ones, it may exhibit a low mechanical robustness, especially when flexure is applied in the installation or lying plane.

Document WO 2015/159126 A1 discloses LED-Lighting modules of LED-light-sources placed on a flexible PCB structure, integrating and providing multiple functions such as static function, isolating function, heat sink, heat abduction to heat dissipating elements (heat piping), ease of automated assembly, and mainly the shaping of freely tailored three dimensional shapes for lighting bulbs or other lighting apparatus with or without the necessity of using additional components providing static, heatsink, electric or other function.

JP 2004 119871 A discloses a multilayer printed board in which a moderate flexibility of a bending part is secured and fracturing of a conductor pattern is prevented to stress applied to the bending part.

US 2014/042406 A1 discloses an electronic device provided with border regions minimized by providing the display with bent edge portions having neutral plane adjustment features that facilitate bending of the bent edge portions while minimizing damage to the bent edge portions.

US 5 434 362 A discloses a flexible circuit board assembly includes a flexible substrate having first and second end portions and an intermediate portion with conductive metalization interconnect paths extending between the substrate end portions and across the intermediate portion. The substrate first and second end portions are mounted to first and second end portions of a rigidizer plate. Stiffening material is provided on the flexible substrate intermediate portion to define stiff and less stiff paths that extend across the interconnect paths and the substrate intermediate portion and define desired bend curvature characteristics for the flexible substrate intermediate portion.

US 2015/0373830 A1 discloses a composite substrate includes a soft layer, a hard layer, a rigid portion and a flexible portion. The soft layer includes a first conductor layer with a conductor pattern and a first flexible insulating layer. The hard layer includes a second conductor layer with a conductor pattern and a second rigid insulating layer. The rigid portion is formed by laminating the soft layer and the hard layer. The flexible portion includes a transition portion which is in proximity to the rigid portion by extending the soft layer and is wider than an interconnect portion.

US 2014/190729 A1 discloses a flexible printed circuit including a first insulating substrate layer and a first electrically conductive layer located adjacent to a first side of the insulating substrate layer. The first conductive layer has a first portion that is substantially solid and a second portion having a multiplicity of voids in the first conductive layer in a pattern for providing a lower stiffness in the second portion relative to the first portion, thereby providing more flexibility in the second portion relative to the first portion.

### Object and Summary

One or more embodiment aim at overcoming the previously outlined drawbacks.

According to one or more embodiments, said object may be achieved thanks to a lighting device having the features specifically set forth in claim 1 that follows.

One or more embodiments may also concern a corresponding method as per claim 10 .

The claims are an integral part of the technical teachings provided herein with reference to the embodiments.

The invention is defined by the appended claims. The embodiments not covered by claim 1 do not form part of the invention but are useful for understanding the invention.

One or more embodiments lead to the achievement of lighting modules adapted to be bent (flexed) both in a direction normal to the installation or lying plane and in the installation or lying plane itself, without jeopardizing the robustness, the reliability and the low ohmic resistance of the power-supply lines, enabling therefore a correct operation even of very long modules.

### Brief Description of the Figures

One or more embodiments will now be described, by way of non-limiting example only, with reference to the annexed Figures, wherein:
- Figure 1 is a view of a lighting device according to one or more embodiments, shown in top view,
- Figure 2, including portions denoted in sequence as a) to f) and h) to l), exemplifies various possible embodiments whereby g) shows an embodiment not forming part of the invention,
- Figure 3, including portions denoted in sequence as a1-a2) to g1-g2), exemplifies various possible embodiments, with the portions denoted by the same letter representing one and the same embodiment observed from two opposite viewpoints (front face / back face), and
- Figure 4, including portions denoted in sequence as a1-a2) to f1-f2), exemplifies further possible embodiments, again with the portions denoted by the same letter representing one and the same embodiment observed from two opposite viewpoints (front face / back face).

It will be appreciated that, for clarity of illustration, the various Figures may not be drawn to the same scale.

### Detailed Description

In the following description, various specific details are given to provide a thorough understanding of various embodiments according to the description. The embodiments may be practiced without one or several of the specific details, or with other methods, components, materials, etc. In other instances, well-known structures, materials, or operations are not shown or described in detail to avoid obscuring various aspects of the embodiments.

Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, particular features, structures, or characteristics may be combined in any suitable manner in one or more embodiments.

The headings provided herein are for convenience only, and therefore do not interpret the extent of protection or the scope of the embodiments.

One or more embodiments concern the possibility of achieving an arbitrary multi-directional bending of a lighting device 10 of the sort which is usually named "flex" module.

In one or more embodiments, device 10 includes a ribbon-like flexible substrate 12, which carries electrically-powered light radiation sources 14 such as solid-state sources, e.g. LED sources.

Said light radiation sources may be associated with various circuits / electrical components, such as e.g. drivers 14a or resistors 14b.

On substrate 12 there are provided electrically conductive portions, adapted to form electrically conductive lines for light radiation sources 14. In one or more embodiments, such lines may be power supply lines, and optionally electrical lines for transferring signals related to the control (dimming, etc.) of the radiation emitted by sources 14.

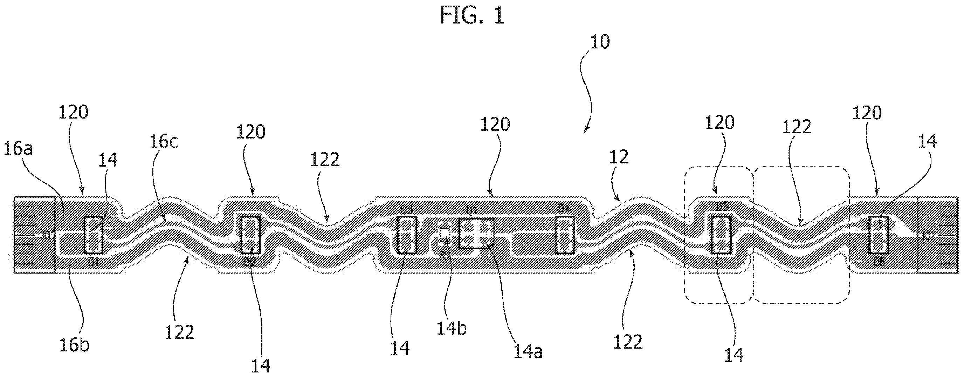

Figure 1 exemplifies the possible presence of electrically conductive portions 16a, 16b and 16c adapted to operate respectively as power supply line (VDD), ground line (GND) and bias line 16c.

Devices such as the presently exemplified device 10 are implemented as ribbon-like flexible elements which may have an indefinite length, which may be adapted to be cut to a desired length according to the application needs.

In one or more embodiments, a device 10 as shown in the Figures may moreover be laminated onto a flexible adhesive tape (which may have a rectangular shape or optionally a shaped profile corresponding to device 10, according to criteria to be better detailed in the following) and/or it may be embedded in an elastomer (e.g. silicone or polyurethane), optionally before being laminated onto the adhesive layer, so as to provide device 10 with protection features, e.g. with an IP protection grade.

Such lighting devices are generally known, which makes it unnecessary to provide a more detailed description herein.

As the device includes a ribbon-like and therefore a generally flat element, device 10 as exemplified in the Figures may generally exhibit an installation or lying plane (corresponding to the plane of the drawing). The ribbon-like structure allows for a relatively easy bending of device 10 in a direction normal to said installation or lying plane. On the contrary, the flexure/bending in the installation or lying plane (i.e. in the plane of the drawing, in the presently annexed Figures) may be more difficult. This is also due to the fact that the light radiation sources 14 (as well as the optionally associated circuits / components 14a, 14b) are usually rigid elements. This may damage sources and components as well as the related electrical connections.

In one or more embodiments, ribbon-like substrate 12 of device 10 includes approximately rectangular flat laminar support structures (a sort of "islands") 120, on which light radiation sources 14 (and the optionally related circuits / components 14a, 14b) may be mounted.

In one or more embodiments, between portions or islands 120 there extend bridge-like flexible portions 122 adapted to have e.g. a meander-like pattern.

In the embodiments, electrically conductive portions 16a, 16b, 16c have, at bridge-like portions 122, a lower (even substantially lower) cross-sectional area than they have at flat laminar support portions ("islands") 120.

This may be appreciated e.g. in Figure 1, wherein the electrically conductive portions 16a, 16b, 16c are shown generally in dark colour, as against the light colour of substrate 12. Reasonably assuming that electrically conductive portions 16a, 16b, 16c have a constant thickness, said cross-sectional area (i.e. the area which would ideally be exposed in a section of device 10 along a plane normal to the longitudinal direction thereof) is practically proportional to the area of substrate 12 covered by electrically conductive portions 16a, 16b, 16c.

As better detailed in the following, bridge-like portions 122 may have different shapes (rectilinear, meander-like such as a 2D-spring, serpentine, etc.), and are adapted to receive electrically conductive portions having different patterns. E.g. such patterns may include either single conductive lines for each "signal" (supply, ground, bias etc.) or a plurality of conductive lines for each signal.

As regards implementation, a device 10 according to one or more embodiments may be designed substantially as a Flexible Printed Circuit (FPC), which may be single-sided or double-sided.

In one or more embodiments, the ribbon-like flexible substrate may comprise a dielectric, e.g. polymeric film (e.g. polyimide, polyethylene terephthalate, polyethylene naphtalate, polycarbonate, polyurethane, polyarylether-etherketone etc.), the electrically conductive portions 16a, 16b, 16c (optionally in a plurality of layers) being adapted to include an electrically conductive material such as a metal (e.g. aluminium, copper or silver).

The electrically conductive portions 16a, 16b, 16c may be applied adhesively onto substrate 12 via various adhesive materials (e.g. epoxy, acrylic, polyester/polyurethane-based, etc.).

In case of a double-sided FCP, "vias" may be provided extending through substrate 12 and forming conductive paths between the electrically conductive portions provided on the opposed faces of substrate 12 itself.

In order to implement the electrically conductive lines it is also possible to resort, according to solutions known in themselves, to etching or printing techniques (e.g. printing with electrically conductive inks). For shaping/profiling substrate 12 (and optionally an associated adhesive layer), the possible techniques are punching, rotary punching, laser cutting or various CNC cutting techniques.

In one or more embodiments, islands 120 in device 10 may be rigid areas, which may be subjected to limited flexural stresses. It is therefore possible to avoid applying of excessive strains to sources 14 and/or to circuits/components 14a, 14b associated thereto, while at the same time avoiding excessive strains to the electrical connections between lines 16a, 16b, 16c and sources 14 as well as circuits/components 14a, 14b.

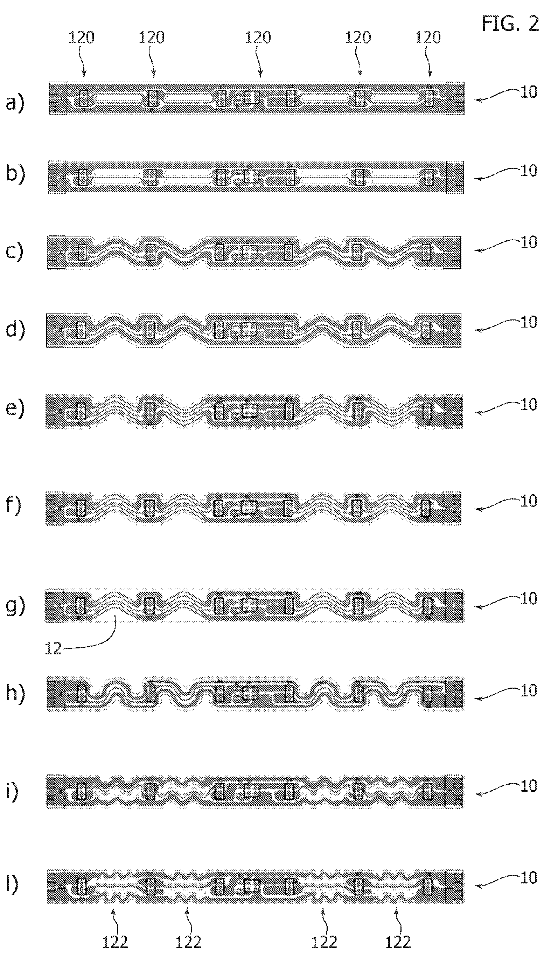

Figures 2 to 4 exemplify (without limitation) a wide range of patterns which may be envisaged for bridge-like formations (122). These may comprise e.g. generally rectilinear patterns, or V-, U-, W-shaped meanders, or serpentine patterns (e.g. sinusoids) with the possibility of different orientations: e.g. a given meander may have an orientation either opposed or equal to the adjoining meander(s).

Moreover, as previously stated, the electrically conductive lines provided at bridge-like formations 122 may be split into plural conductive lines adapted to convey the same signal, so as to further reduce the cross-sectional area of the electrically conductive material (e.g. metal) which may be less flexible than the (e.g. polymeric) material of substrate 12.

In one or more embodiments, the presence of bridge-like portions 122 interposed between islands 120 (the latter being substantially rigid) enables the flexure of device 10 at bridge-like portions 122 in multiple directions, i.e.:
- in the installation/lying plane of device 10 (the plane of the drawing in the present Figures),
- in a direction normal to such an installation/lying plane, and
- in any direction deriving from the combination of both previously exemplified flexing/bending possibilities, including a lengthwise (i.e. helicoidal) twisting of device 10 along the length thereof.

In order not to overburden the graphical representation, most references appearing in Figure 1 have been omitted in Figures 2 to 4, wherein the electrically conductive portions are shown in an overall dark colour, as in portions 16a, 16b, 16c of Figure 1, as against an overall light colour of substrate 12.

In this respect, it will be appreciated that the main goal of Figures 2 to 4 is exemplifying possible patterns of the electrically conductive portions 16a, 16b, 16c in a structure of device 10 as exemplified in Figure 1.

In Figures 2 to 4, the shape of the outer edge of substrate 12 (which, except for the example of portion g) of Figure 2, is assumed to follow the external profile of the electrically conductive portions 16a, 16b, 16c) may therefore not be directly perceivable.

Specifically, in Figures 2 to 4 the alternation is shown of islands 120 (carrying the light radiation sources 14 and the optionally associated circuits/components 14a, 14b) and of bridge-like portions 122 interposed between portions 120.

The examples shown in Figures 2 to 4 refer to devices 10 comprising five islands 120 and four bridge-like portions 122 extending therebetween: of course, this choice is merely exemplary.

Portions a) and b) in Figure 2 exemplify possible embodiments wherein bridge-like portions 122 have an overall rectilinear pattern, while keeping a reduction of the cross-sectional area of the electrically conductive formations at such portions.

Portion c) in Figure 2 exemplifies the possible implementation of meander-like bridge portions 122 (e.g. V-shaped portions), with sequentially alternating orientations (convex/concave). Such a choice has been proven to simplify bending, while keeping rather large sections for the electrical lines such as supply lines (VDD) and ground lines (GND).

Portion d) in Figure 2 exemplifies a solution wherein the meanders having a V-shaped profile have a concordant orientation along the whole length of device 10. This solution may lead to a preferential bending direction (the direction of the concavity of bridge-like portions 122) and/or to an improved reliability, by reducing the strains applied onto sources 14 and circuits/components which may be associated thereto.

The solutions exemplified in portions e) and f) of Figure 2 are basically similar to the solutions exemplified in portions c) and d), the difference being given by the fact that the electrically conductive portions have a cross-sectional area which is further reduced, as they have been split into several portions, e.g. by being traversed by longitudinal slots.

The configuration, exemplified in portion g) of Figure 2, not forming part of the invention, is substantially similar to portion f), the difference being that, in the case exemplified in portion g) of Figure 2, substrate 12 may have a general rectangular profile, which does not follow the shape of the electrically conductive portions at bridge-like portions 122. One or more embodiments as exemplified in portion g) of Figure 2 enable avoiding a processing step of substrate 12, without jeopardizing the flexibility properties of device 10.

Portion h) in Figure 2 exemplifies the possibility of implementing bridge-like portions 122 with a U-shaped profile, while always keeping a meander-like pattern (which in this case is approximately sinusoidal or serpentine-like).

Portions i) and l) in Figure 2 exemplify the possibility of implementing bridge-like portions 122 with a serpentine (e.g. sinusoidal) pattern, each bridge-like portion having a serpentine pattern.

A comparison of portions i) and l) of Figure 2 highlights the possibility, in the implementation of bridge-like portions 122, of varying both the "wavelength" and the "width" of the sinusoidal pattern of the serpentine formations.

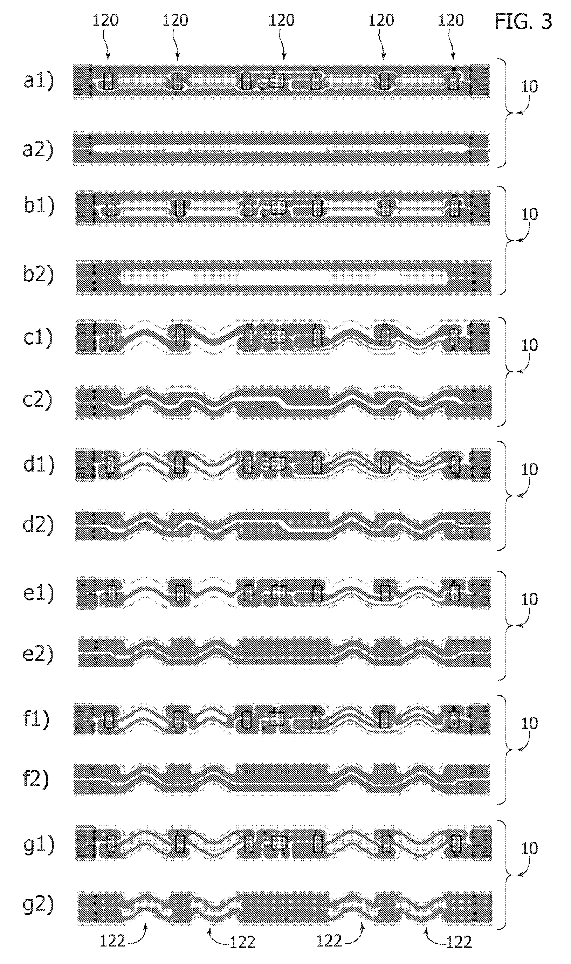

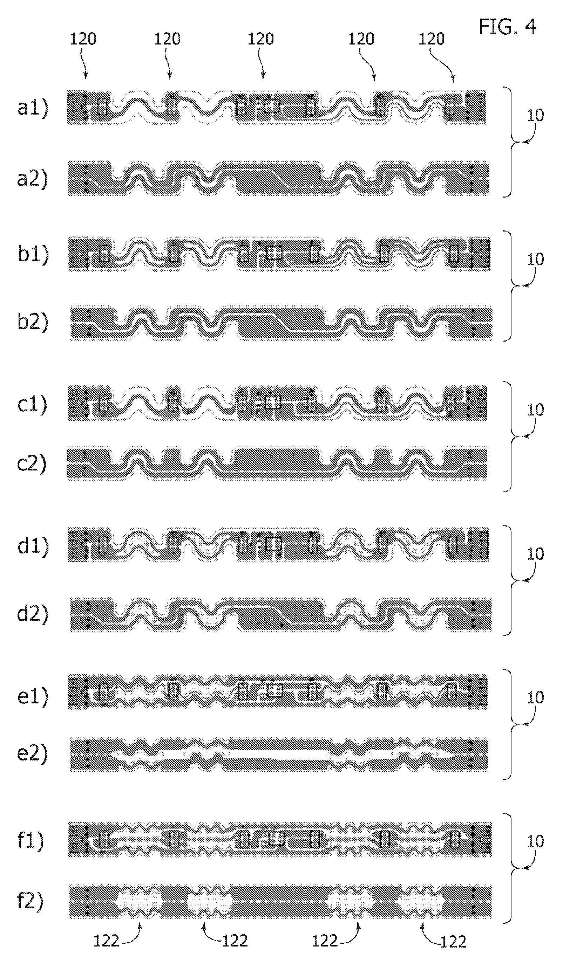

Figure 3 and Figure 4 exemplify various possibilities offered by resorting to double-sided solutions, with the consequent possibility of providing electrically conductive portions (again shown in Figures 3 and 4 in dark colour, as opposed to the light colour of substrate 12) with different patterns on both faces of substrate 12, i.e. on the front face (suffix "1" in the Figures) carrying sources 14 and on the back face (suffix "2" in the Figures).

Portions a1), a2) and b1), b2) of Figure 3 (where it is possible to notice the different patterns of the electrically conductive portions on both faces of substrate 12) exemplify the possibility of implementing bridge-like portions 122 having an overall rectilinear pattern, with the cross-sectional areas of the electrically conductive portions which are lower in portions b1) and b2) than in portions a1) and a2).

Portions c1), c2) and d1), d2) exemplify the possibility of implementing bridge-like portions 122 having a meander-like pattern, the patterns being mutually corresponding on both faces of substrate 12, e.g. with the possibility of implementing complementary patterns on both faces of the substrate.

This may also involve involves (see e.g. portion d1) of the Figure) the presence of electrically conductive portions which form grooved electrically conductive lines, i.e. lines traversed by longitudinal slots.

Portions e1), e2) and f1), f2) ideally correspond to portions c1), c2) and d1), d2), the difference being given by the concordant orientation of the meanders, as opposed to a possible orientation in opposed directions.

As previously stated with reference to portion d) or portion f) of Figure 2, the concordant orientation of the meanders may originate a preferential bending direction, which is adapted to improve reliability.

Portions g1), g2) of Figure 3 exemplify, referring by way of example to opposed meander-like patterns, the possibility of achieving a clear reduction of the cross-sectional area of the electrically conductive portions, by acting on both faces of substrate 12.

In Figure 4 (with the same representation of the previous Figures) the possibility is exemplified of implementing U-shaped meander-like patterns on both faces of the substrate (portions a1) and a2)), so that the flexing/bending of device 10 may be further supported.

Portions b1), b2) exemplify various possibilities of splitting, via longitudinal slots, the electrically conductive portions, e.g. on the lower or back face of device 10, so as to create a redundancy in the power supply lines.

Portions c1), c2) of Figure 4 highlight the possibility of having a uniform orientation of the meanders, so as to create a preferential bending direction with a consequent increase in reliability.

Portions d1), d2) exemplify the possibility of splitting the electrically conductive lines on both faces, determining therefore a reduction in the cross-sectional area.

Moreover, portions e1), e2) and f1), f2) of Figure 4 exemplify the possibility of implementing, optionally on both faces of substrate 12, bridge-like portions 122 comprising serpentine-shaped (sinusoidal) electrically conductive portions, the possibility being given again of varying both the wavelength and the width of the sinusoidal wave forms.

It will be appreciated that the specific implementation details exemplified with reference to any one of the Figures are not to be considered as exclusively related to the embodiments exemplified in such a Figure, as they may be freely transferred to embodiments exemplified in any other Figure.

Without prejudice to the basic principles, the implementation details and the embodiments may vary, even appreciably, with respect to what has been described herein by way of non-limiting example only, without departing from the extent of protection.

The extent of protection is defined by the annexed claims.

## Claims

1. A lighting device, including a flexible ribbon-like substrate (12) with electrically-powered light radiation sources (14) thereon as well as electrically conductive portions (16a, 16b, 16c) providing electrically conductive lines for the light radiation sources (14),
wherein:
- the device (10) is embedded in an elastomer providing ingress protection of the device,
- the flexible ribbon-like substrate (12) includes approximately rectangular laminar support portions (120) for light radiation sources (18) arranged thereon and bridge-like portions (122) extending between said laminar support portions (120),
- the electrically conductive portions (16a, 16b, 16c) have at said bridge-like portions (122) a lower cross-sectional area than at said laminar support portions (120),
- the shape of the outer edge of the substrate (12) follows the external profile of the electrically conductive portions (16a, 16b, 16c),
- the device includes electrically conductive portions (16a, 16b, 16c) having longitudinal slots therein.

2. The lighting device of claim 1, wherein said substrate (10) includes dielectric material, preferably polymeric material.

3. The lighting device of claim 1 or claim 2, wherein said electrically conductive portions (16a, 16b, 16c) are provided on both faces of said flexible ribbon-like substrate (12).

4. The lighting device of any of the previous claims, wherein said electrically conductive portions (16a, 16b, 16c) include metal material, preferably selected out of aluminium, copper or silver.

5. The lighting device of any of the previous claims, wherein said electrically conductive portions (16a, 16b, 16c) are etched, printed or applied adhesively on said flexible ribbon-like substrate (12).

6. The lighting device of any of the previous claims, wherein said bridge-like portions (122) are rectilinear.

7. The lighting device of any of claims 1 to 6, including a meander-like pattern of bridge-like portions (122).

8. The lighting device of claim 7, wherein said meander-like pattern includes bridge-like portions (122) having:
- concordant concavities for all the bridge-like portions (122) in the lighting device (10), or
- opposed concavities in an alternate sequence over the length of the lighting device (10).

9. The lighting device of any of the previous claims, wherein said electrically-powered light radiation sources (14) include LED sources.

10. A method of providing a lighting device (10), the method including:
- providing a flexible ribbon-like substrate (12) with electrically-powered light radiation sources (14) thereon as well as electrically conductive portions (16a, 16b, 16c) providing electrically conductive lines for the light radiation sources (14),
- providing in said flexible ribbon-like substrate (12) approximately rectangular laminar support portions (120) for light radiation sources (18) arranged thereon and bridge-like portions (122) extending between said laminar support portions (120), the electrically conductive portions (16a, 16b, 16c) having at said bridge-like portions (122) a lower cross-sectional area than at said laminar support portions (120), wherein the shape of the outer edge of the substrate (12) follows the external profile of the electrically conductive portions (16a, 16b, 16c) and the electrically conductive portions (16a, 16b, 16c) have longitudinal slots therein, and
- embedding the device (10) in an elastomer providing ingress protection of the device.

## Patentansprüche

1. Beleuchtungsgerät, beinhaltend ein flexibles bandartiges Substrat (12) mit darauf befindlichen elektrisch betriebenen Lichtstrahlungsquellen (14) sowie elektrisch leitende Abschnitte (16a, 16b, 16c), die elektrisch leitende Leitungen für die Lichtstrahlungsquellen (14) bereitstellen, wobei:
- das Gerät (10) in ein Elastomer eingebettet ist, das Schutz gegen Eindringen für das Gerät bereitstellt,
- das flexible bandartige Substrat (12) annähernd rechteckige laminare Trägerabschnitte (120) für darauf angeordnete Lichtstrahlungsquellen (18) und brückenartige Abschnitte (122), die sich zwischen den laminaren Trägerabschnitten (120) erstrecken, beinhaltet,
- die elektrisch leitenden Abschnitte (16a, 16b, 16c) an den brückenartigen Abschnitten (122) eine geringere Querschnittsfläche aufweisen als an den laminaren Trägerabschnitten (120),
- die Form der Außenkante des Substrats (12) dem Außenprofil der elektrisch leitenden Abschnitte (16a, 16b, 16c) folgt,
- das Gerät elektrisch leitende Abschnitte (16a, 16b, 16c) mit Längsschlitzen darin beinhaltet.

2. Beleuchtungsgerät nach Anspruch 1, wobei das Substrat (10) dielektrisches Material, vorzugsweise Polymermaterial, beinhaltet.

3. Beleuchtungsgerät nach Anspruch 1 oder 2, wobei die elektrisch leitenden Abschnitte (16a, 16b, 16c) auf beiden Seiten des flexiblen bandartigen Substrats (12) bereitgestellt sind.

4. Beleuchtungsgerät nach einem der vorhergehenden Ansprüche, wobei die elektrisch leitenden Abschnitte (16a, 16b, 16c) metallisches Material beinhalten, vorzugsweise ausgewählt aus Aluminium, Kupfer oder Silber.

5. Beleuchtungsgerät nach einem der vorhergehenden Ansprüche, wobei die elektrisch leitenden Abschnitte (16a, 16b, 16c) auf das flexible bandartige Substrat (12) geätzt, gedruckt oder aufgeklebt sind.

6. Beleuchtungsgerät nach einem der vorhergehenden Ansprüche, wobei die brückenartigen Abschnitte (122) geradlinig sind.

7. Beleuchtungsgerät nach einem der Ansprüche 1 bis 6, das ein mäanderförmiges Muster aus brückenartigen Abschnitten (122) beinhaltet.

8. Beleuchtungsgerät nach Anspruch 7, wobei das mäanderartige Muster brückenartige Abschnitte (122) beinhaltet, die Folgendes aufweisen:
- übereinstimmende Konkavitäten für alle brückenartigen Abschnitte (122) in dem Beleuchtungsgerät (10), oder
- entgegengesetzte Konkavitäten in einer abwechselnden Reihenfolge über die Länge des Beleuchtungsgeräts (10).

9. Beleuchtungsgerät nach einem der vorhergehenden Ansprüche, wobei die elektrisch betriebenen Lichtstrahlungsquellen (14) LED-Quellen beinhalten.

10. Verfahren zum Bereitstellen eines Beleuchtungsgeräts (10), das Verfahren beinhaltend:
- Bereitstellen eines flexiblen bandförmigen Substrats (12) mit darauf angeordneten elektrisch betriebenen Lichtstrahlungsquellen (14) sowie elektrisch leitenden Abschnitten (16a, 16b, 16c), die elektrisch leitende Leitungen für die Lichtstrahlungsquellen (14) bereitstellen,
- Bereitstellen in dem flexiblen bandartigen Substrat (12) annähernd rechteckiger laminarer Trägerabschnitte (120) für darauf angeordnete Lichtstrahlungsquellen (18) und brückenartiger Abschnitte (122), die sich zwischen den laminaren Trägerabschnitten (120) erstrecken, wobei die elektrisch leitfähigen Abschnitte (16a, 16b, 16c) an den brückenartigen Abschnitten (122) eine geringere Querschnittsfläche als die laminaren Trägerabschnitte (120) aufweisen, wobei die Form der Außenkante des Substrats (12) dem Außenprofil der elektrisch leitenden Abschnitte (16a, 16b, 16c) folgt und die elektrisch leitenden Abschnitte (16a, 16b, 16c) Längsschlitze darin aufweisen, und
- Einbetten des Geräts (10) in ein Elastomer, das Schutz gegen Eindringen für das Gerät bereitstellt.

## Revendications

1. Un dispositif d'éclairage, comprenant un substrat flexible en ruban (12) avec dessus des sources de rayonnement lumineux alimentées électriquement (14), ainsi que des parties électriquement conductrices (16a, 16b, 16c) formant des lignes électriquement conductrices pour les sources de rayonnement lumineux (14),
dans lequel :
- le dispositif (10) est noyé dans un élastomère assurant une protection du dispositif contre l'infiltration,
- le substrat flexible en ruban (12) comprend des parties laminaires de support approximativement rectangulaires (120) pour les sources de rayonnement lumineux (18) agencées dessus, et des parties en pont (122) s'étendant entre lesdites parties laminaires de support (120),
- les parties électriquement conductrices (16a, 16b, 16c) ont au niveau desdites parties en pont (122) une surface en section droite qui est plus faible qu'au niveau desdites parties laminaires de support (120),
- la forme du bord extérieur du substrat (12) suit le profil externe des parties électriquement conductrices (16a, 16b, 16c),
- le dispositif comprend des parties électriquement conductrices (16a, 16b, 16c) avec dedans des fentes longitudinales.

2. Le dispositif d'éclairage de la revendication 1, dans lequel ledit substrat (10) comprend un matériau diélectrique, de préférence un matériau polymère.

3. Le dispositif d'éclairage de la revendication 1 ou de la revendication 2, dans lequel lesdites parties électriquement conductrices (16a, 16b, 16c) sont disposées sur les deux faces dudit substrat flexible en ruban (12).

4. Le dispositif d'éclairage de l'une des revendications précédentes, dans lequel lesdites parties électriquement conductrices (16a, 16b, 16c) comprennent un matériau métallique, de préférence choisi parmi l'aluminium, le cuivre ou l'argent.

5. Le dispositif d'éclairage de l'une des revendications précédentes, dans lequel lesdites parties électriquement conductrices (16a, 16b, 16c) sont gravées, imprimées, ou appliquées par adhésion sur ledit substrat flexible en ruban (12).

6. Le dispositif d'éclairage de l'une des revendications précédentes, dans lequel lesdites parties en pont (122) sont rectilignes.

7. Le dispositif d'éclairage de l'une des revendications 1 à 6, comprenant un motif en méandres de parties en pont (122) .

8. Le dispositif d'éclairage de la revendication 7, dans lequel ledit motif en méandres comprend des parties en pont (122) possédant :
- des concavités concordantes pour toutes les parties en pont (122) du dispositif d'éclairage (10), ou
- des concavités opposées en une séquence alternée sur la longueur du dispositif d'éclairage (10).

9. Le dispositif d'éclairage de l'une des revendications précédentes, dans lequel lesdites sources de rayonnement lumineux électriquement alimentées (14) comprennent des sources LED.

10. Un procédé d'obtention d'un dispositif d'éclairage (10), le procédé comprenant :
- l'obtention d'un substrat flexible en ruban (12) avec dessus des sources de rayonnement lumineux électriquement alimentées (14), ainsi que des parties électriquement conductrices (16a, 16b, 16c) formant des lignes électriquement conductrices pour les sources de rayonnement lumineux (14),
- l'obtention dans ledit substrat flexible en ruban (12) de parties laminaires de support approximativement rectangulaires (120) pour les sources de rayonnement lumineux (18) disposées dessus, et de parties en pont (122) s'étendant entre lesdites parties laminaires de support (120), les parties électriquement conductrices (16a, 16b, 16c) ayant au niveau desdites parties en pont (122) une surface en section droite qui est plus faible qu'au niveau desdites parties laminaires de support (120), la forme du bord externe du substrat (12) suivant le profil externe des parties électriquement conductrices (16a, 16b, 16c) et les parties électriquement conductrices (16a, 16b, 16c) ayant des fentes longitudinales dedans, et
- l'incorporation du dispositif (10) dans un élastomère assurant une protection du dispositif contre l'infiltration.
